(19) Europäisches Patentamt

European Patent Office

Office européen des brevets

(11) **EP 2 337 070 A1**

(12) **EUROPEAN PATENT APPLICATION**

(43) Date of publication:
**22.06.2011 Bulletin 2011/25**

(51) Int Cl.:
**H01L 23/498** (2006.01)          **H01L 23/62** (2006.01)

(21) Application number: **09179630.0**

(22) Date of filing: **17.12.2009**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(71) Applicant: **ABB Technology AG**
**8050 Zürich (CH)**

(72) Inventors:
• **Greuter, Felix**
**CH-5406, Baden-Rütihof (CH)**

• **Schuderer, Juergen**
**CH-8047, Zürich (CH)**
• **Donzel, Lise**
**CH-5430, Wettingen (CH)**

(74) Representative: **ABB Patent Attorneys**
**C/o ABB Schweiz AG**
**Intellectual Property (CH-LC/IP)**
**Brown Boveri Strasse 6**
**5400 Baden (CH)**

(54) **Electronic device with non-linear resistive field grading and method for its manufacturing**

(57)     The invention relates to an electronic device comprising a substrate (2), a metal layer (3, 4, 5) formed on the substrate (2) and a field grading means (17, 23) located along an edge (12 to 16) of the metal layer (3, 4, 5). The field grading means (17) has a non-linear electrical resistivity. The invention relates also to method to produce such an electronic device.

Fig. 1

EP 2 337 070 A1

**Description**

The invention relates to an electronic device with a field grading according to the preamble of claim 1 and to a method for producing such an electronic device.

In electrical devices, electric field enhancements may occur at conductive components with small radius of curvature as for example tips and edges of electrodes, semiconductors or metallic particles. Such electric field enhancements may lead to partial discharges and electrical breakdown, which lead to damage and failure of the electronic device.

In order to avoid such field enhancements, that is, in order to grade the electric field, the geometries of the components can be changed, e.g., by rounding tips and edges, which is efficient, robust and reliable. In addition, this geometric field grading is not affected by the frequency of the voltage applied to the electronic device. However, it is not always possible to avoid sharp edges. In power electronic substrates for example, the application of Copper electrodes on ceramic substrates by bonding or brazing does not easily allow a 3D-bended geometry of the electrodes.

It is also known from prior art, that materials with selected electrical resistivity or high permittivity can be placed in the regions in which the electric field is to be graded. However, known field grading strategies provide either only small efficiency or exhibit unwanted side-effects as for example high leakage currents and frequency dependencies.

US6310401 discloses an electrical component with a high-impedance layer bridging top and bottom metallization of a metallic-ceramic substrate. In this way, a linear resistive field grading is achieved. This kind of field grading however, is limited mainly by the strong sensitivity to the specific choice of the resistivity value: It can only be applied for a narrow resistivity window in which the resistivity is low enough to provide some field grading and at the same time is high enough to keep leakage currents, and therefore losses, sufficiently small. Additionally, the linear resistive field grading is restricted by its frequency dependence, meaning that the penetration of the electric potential from the metallization end into the field grading layer, and in this way the effectiveness of the field grading depends on the frequency of the voltage signal. As an example, HV power electronic devices, such as IGBT modules, have to pass a partial discharge test at a frequency of 50Hz, whereas frequency components up to several kHz are present during operation. In this way, field grading performance cannot be optimum for test and operational conditions at the same time.

US20010014413 discloses a substrate for HV modules with a high permittivity layer in contact to an electrode edge. In this way, a linear refractive field grading is achieved. This linear refractive field grading however, is mainly limited by the fact that high-permittivity materials often have high losses and low breakdown strength. There is another issue when using refractive field grading for common HV power electronic substrates, which is that the permittivity of the field grading means has to be chosen particular high since usually a AIN ceramic is used which has already a quite high relative permittivity $\varepsilon_{AIN} = 8.5\text{-}10$ and because the quality of refractive field grading is largely determined by the permittivity ratio $\varepsilon_{layer} / \varepsilon_{substrates}$

It is thus the object of the invention to provide a system for electronic modules with improved field grading efficiency and with minimum leakage current and frequency dependencies.

The problem is solved by the electronic device according to claim 1. The electronic device according to the invention comprises an insulating substrate for carrying semiconductor components, at least one metal layer formed on the substrate and a field grading means located on the substrate along at least one edge formed between the at least one metal layer and the insulating substrate. The field grading means has a non-linear electrical resistivity.

The problem is also solved by the methods according to claim 14 and 18. The method for producing an electronic device comprises the following steps. At least one metal layer is formed on a substrate. A field grading means with nonlinear electrical resistivity is arranged on at least one edge of at least one metal layer.

The field grading means is made of a non-linear electrical material, i.e. of a material with non-linear electrical resistivity. The non-linear electrical material is preferably designed to have a suitable switching field strength. The switching field strength is the electric field strength at which the material switches from insulating mode into conductive mode. On the one hand, this means the field grading means remains insulating during normal operation voltages of the electronic device and prevents undesired leakage currents. On the other hand, the field grading means becomes locally conductive during over-voltage conditions, e.g., during tests, and thereby efficiently reduces electric field enhancements that might otherwise lead to partial discharges and electrical breakdown. Consequently, efficient normal operation and the elimination of partial discharges and breakdown during over-voltages are reached with the nonlinear field grading means.

"locally conductive" means conductive in an area, in which the electric field exceeds the switching field strength. Further, "locally conductive" means that between two electrodes which are in contact to the field grading means at most leakage current flows. This leakage current, which flows through the field grading means should be at most of the order of the leakage current which flows through a semiconductor chip in his blocking state connected to the same electrodes.

Compared to linear resistive field grading, major benefits of using non-linear resistive field grading are (1) leakage currents occur only upon very high electric field strengths and not at operational conditions and (2) the frequency dependence of the field grading is considerably improved. This effect is outlined by referring to Rhyner et al., "One-dimensional model for nonlinear stress control in cable terminations", IEEE Transactions on Dielectrics and Electrical Insulation, Vol. 4, No. 6, pp. 785-791, 1997. In this paper, a penetration length l is evaluated, which corresponds to the distance from the metallization end at which the electric potential within the field grading material is reduced to a fraction of l/e (e is the Euler's number). It is found that

$$l \sim \omega^{-\frac{1}{\alpha+1}} \cdot U_0^{\frac{\alpha-1}{\alpha+1}} \tag{1}$$

whereby w is the angular frequency and $\alpha$ is the nonlinearity coefficient, defined by a nonlinear power law for the current density j according to

$$j = j_c \cdot \left(\frac{E}{E_c}\right)^{\alpha} \tag{2}$$

with $E_c$ being the critical switching field strength. $U_0$ is the voltage amplitude. We can see now that for a linear resistive material with $\alpha = 1$, the penetration length is frequency dependent with $l \sim 1/\sqrt{f}$, i.e., the higher the frequency, the less the penetration. For the nonlinear resistive grading however with $\alpha \gg 1$, the frequency dependence is negligible and the penetration depends only on the applied voltage. In particular, leakage currents only occur when the penetration reaches levels of the insulation distance between the electrodes.

Other features considered as characteristic for the invention are set forth in the appended claims.

It is further advantageous to arrange more than one metal layer on the substrate and to cover more than one edge by the same field grading means.

The current-voltage characteristics of the field grading means shows a nonlinearity coefficient larger than two, in particular larger than five and preferably larger than ten in the region of the switching field strength. Thus, a sharp transition between insulating and conducting mode is reached at a well-defined switching field strength. Large nonlinearity coefficients reduce leakage currents and provide a penetration length that is not much affected by the frequency.

It is advantageous that the switching field strength is larger than half of the ratio of the maximum critical test voltage of the electronic device and the length of the field grading means in the direction being parallel to the substrate surface and leading away from the edge.

It is further advantageous that the field grading means comprises an insulating high breakdown strength matrix and a filler material, in particular a microvaristor filler. A microvaristor filler is a granular material that exhibit varistor properties ,i.e., non-linear electrical resistance. Preferably, the non-linear filler comprises ZnO and/or doped ZnO particles with a particle size of less than 100$\mu$m, preferably < 50$\mu$m and most preferably < 30$\mu$m. Non-linear electrical resistive field grading is achieved by the non-linear filling material. Preferably, the field grading mean is arranged as a layer. However, it is also possible that a encapsulation of the substrate is the field grading means.

Preferably, the insulating high breakdown strength matrix comprises at least one further filler, wherein the filler is a semiconductor or a high permittivity material. It is further advantageous that the at least one further filler has a reduced particle size compared to the microvaristor filler.

Preferably the semiconducting filling material is a powder of semiconducting filler material comprising $SnO_2$, SiC, doped $SnO_2$, carbon black or other forms of carbon and/or coated micro-mica particles in a preferred size range from below 1 $\mu$m up to 10$\mu$m. Free spaces between the non-linear particles, i.e. microvaristor-particles, may be filled with particles of the semiconducting filling material. Thus, field grading can be optimised even in free spaces between the non-linear particles, in particular in the vicinity of the metal edges, where large microvaristor particles may not reach close enough. Due to the semiconducting filler material, a resistive field grading is achieved locally in addition to the non-linear resistive field. However, the amount of semiconductor filler has to be restricted such that the semiconductor filler remain under a threshold of percolation.

The field grading means can also or additionally further be filled up by a high-permittivity (= high-$\varepsilon$) material. The high-$\varepsilon$ filling material is preferably a powder of high-$\varepsilon$ filler material, such as $TiO_2$, $BaTiO_3$ or other Titanates, in the advantageous size range from below 1 $\mu$m up to 10$\mu$m. The particles of the high-$\varepsilon$ filling material may be used to fill free spaces between the non-linear particles. Field grading performance, in particular in the vicinity of the metal edges, can thus be enhanced locally even in free spaces between the non-linear particles. Due to the high-$\varepsilon$ filler material, refractive field grading is achieved in addition to the non-linear resistive field grading.

Also, a mixture of semiconducting filler material and high-$\varepsilon$ filler material may be used in the free spaces between the non-linear particles. In this case, an advantageous mixture of non-linear resistive field grading, resistive field grading and refractive field grading is achieved. Field grading performance is further enhanced.

Due to the small semiconductor filling material particles and to the small high-ε filling material particles, field grading may be achieved everywhere where it is needed; even in sharp and/or peaked edges and peaks.

It is further advantageous that the field grading means is sealed against the environment with a passivation layer.

In a preferred embodiment, the field grading means comprise a matrix (e.g., a high strength insulating layer, e.g. polyimide and/or an electrically insulating gel or a hot melt or low melting glass) in which either the non-linear filling material or the non-linear filling material and the semiconducting filling material and/or the high-ε filling material are embedded.

The field grading means is advantageously realized by (1) mixing the microvaristor filler and/or the at least one further filler in a liquid polymer matrix, (2) applying the mixture on the substrate by needle-dispensing, printing, painting, coating or spraying and (3) curing the mixture by heat, Ultraviolet radiation or other means.

Alternatively, the microvaristor filler and/or the at least one further filler could be placed or pressed on the substrate. In this case, an adhesive can be applied first on the substrate in order to fix the fillers. Then, the insulating matrix is applied afterwards and infiltrates the filler-bed.

It is especially advantageously, to seal the filler on the substrate with a thin passivation film, in particular by a polymer, preferably Polyimide. This has the advantage that the microvaristor particles, e.g. ZnO-particles, are protected from environmental conditions that might affect their electrical characteristics. For example, in order to activate Copper surfaces, HV substrates are exposed to reducing atmosphere during soldering of substrates onto the base plate of a module. The reducing atmosphere may give rise to chemical reactions with the filler particles, and in this way modify their electrical characteristics which may lead to reduced microvaristor capability. A glass layer might also be used as passivation.

In another embodiment, the field grading means comprises

(1) a localized layer of semiconducting or high-ε fillers of particle size below 1 μm up to 10μm right next the edge of electrodes and (2) a second layer of non-linear restive field grading layer covering said first layer.

The invention will be explained in more detail in the following description with reference to embodiments shown in the figures, in which:

Fig. 1     shows part of the cross section of a first inventive electronic device with a field grading means;

Fig. 2     shows a characteristic resistivity-electric field strength-curve of the field grading means;

Fig. 3     shows part of the cross section of a second inventive electronic device with a field grading means;

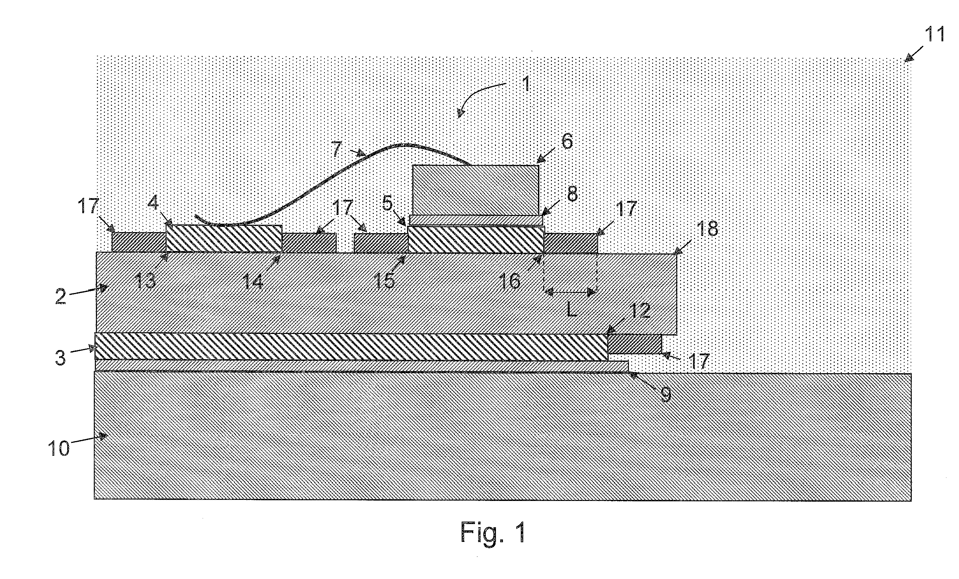

Fig. 1 shows a cross-section of a part of an electronic device 1 as part of a power electronic module according to a first embodiment of the invention. The electronic device 1 comprises an insulating substrate 2, preferably a ceramic substrate like aluminium nitride AIN. The insulating substrate 2 is sandwiched by a metal layer 3 on the first side of the insulating substrate 2 and a plurality of metal layers 4, 5 on the second side opposite of the first side. However, the invention is not restricted by the number of metal layers 3, 4 and 5. A insulating substrate 2 with only one metal layer is also possible. Metal layers 3, 4 and 5 are normally realized in Copper (Cu). The metal layers 4 and 5 could be for example electrodes for semiconducting chips 6, bond wires 7, current load-carrying terminals, control terminals, conductor tracks or passive elements such as resistors. For example, the semiconductor chips 6 are insulated gate bipolar transistors (IGBT) and diodes. Power electric modules based on the electronic device 1 with an IGBT as the semiconductor component 6 are commonly called IGBT modules. The semiconductor chip 6 can be fixed on the metal layer 5 by a soldering layer 8.

The electronic device 1 is normally bonded with the metal layer 3 on the first side via another solder layer 9 to a base plate 10, which is used as heat sink. The electronic device 1 is encapsulated in a soft dielectric 11, which is usually Silicone gel. Instead of the encapsulation by the Silicone gel, encapsulation by another dielectric gel, inert gas or a dielectric liquid is also possible.

For high current capability, several such substrates 2 are usually soldered on the same base plate 10 and are connected in parallel. A plastic casing surrounds all substrates including the soft dielectric 11 and only the terminals are accessible from outside.

The conducting metal layers 4 and 5 of the electronic device 1 as part of a power semiconductor module are normally operated at very high voltages, typically between 800 V and 8 kV. Therefore, strong electric field enhancements are present, especially at edges 12, 13, 14, 15, and 16 between the metal layers 3, 4 and 5 and the substrate 2, as typically at least one of the metal layers 4, 5 on the second side of the insulating ceramic 2 is on the very high voltage level and the metal layer 3 on the first side is grounded. This could lead to the ignition of partial discharges at these edges and consequently, to an electrical breakdown of the electronic device.

Therefore, the inventive field grading means 17, which has a non-linear electrical resistivity, is arranged at the edges 12 to 16 to protect the electronic device 1 from partial discharges.

It is advantageous to cover the entire edge around each metal layer and the insulating substrate 2 by the field grading means 17. However, due to the geometric arrangement of the metal layers 3, 4, 5, semiconducting chips 6, bond wires 7, current load-carrying terminals, control terminals and/or passive elements to each other or other reasons could prevent the covering of the entire edge around each metal layer. It is however still advantageous to cover only a part of the edge around each or some metal layers. In particular it is advantageous to cover at least 50% of the length of the edges around the metal layers 3, 4, 5, more preferably 80% and most preferably 90% of the length of the edges around the metal layers 3, 4, 5.

The field grading means 17 according to a first embodiment is made of or at least comprises a granular material with varistor properties. That is that the resistivity of the granular material of the field grading means 17 shows a non-linear resistivity behaviour as function of the electric field strength.

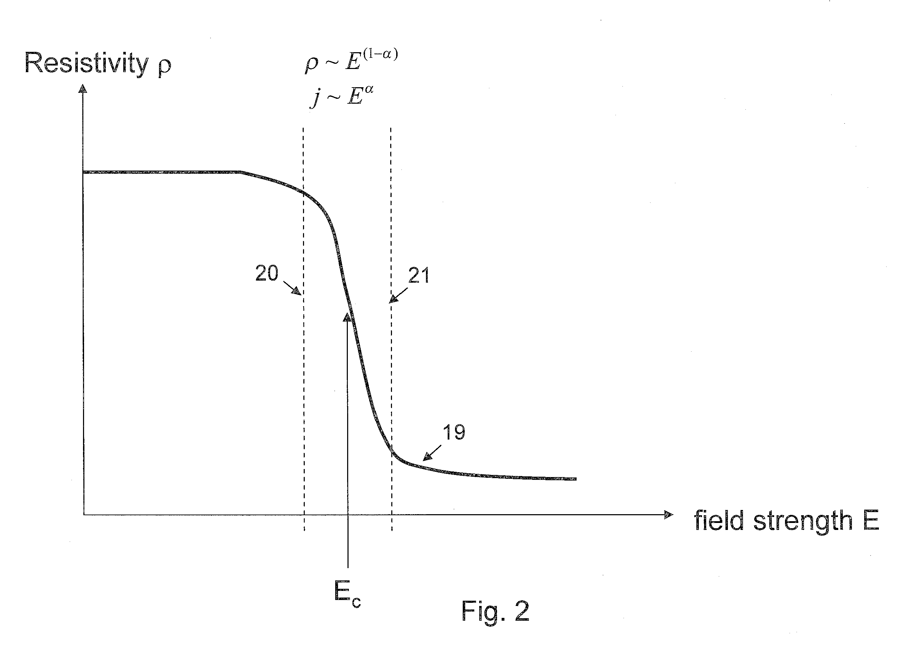

Fig. 2 shows such a characteristic resistivity-electric field strength-curve 19 of a material with varistor properties. Typically a material with varistor properties is also referred to as varistor type material. Such varistor type material remains insulating, i.e. shows high resistance, at low field strengths. The varistor type material further shows a transition at a switching field strength $E_c$ and becomes conductive for electrical field strengths being higher than the switching field strength $E_c$. The switching field strength $E_c$ is defined as the point where the resistivity is dramatically reduced. More precisely, the switching electric field strength $E_c$ is the turning point of the characteristic resistivity-electric field strength-curve 19. The transition behaviour in the switching region shown in Fig. 2 between the dashed vertical lines 20 and 21 is characterised by $p \sim E^{(1-\alpha)}$ and $j \sim E^a$ with the nonlinearity coefficient $\alpha$, whereby p denotes the electrical resistivity, j the current density, and E the electric field strength. The varistor material shows more or less constant ohmic resistivity outside of the switching region.

The switching field strength $E_c$ is preferably larger than 0.5 x $U_{max}$/L, in particular larger than 0.8 x $U_{max}$/L with $U_{max}$ being the maximum voltage during a critical test with respect to partial discharges or electrical breakdown. The length L is shown in Fig. 1 and is the dimension of the field grading means 17 in the direction parallel to the surface of the substrate 2 and perpendicular to the edge. The said condition for $E_c$ guarantees that a considerable part of the voltage drop occurs along the field grading means 17 and in this way provides an effective field grading. Thus, partial discharges and electrical breakdown are prevented. The relation can be understood by referring to equation (1), which shows that the penetration length I is linear dependent upon the voltage amplitude $U_{max}$ for that case that $\alpha \gg 1$.

As an example, the IEC 61287 insulation test procedure for 6.5kV IGBT modules foresees a partial discharge testing at an AC peak voltage of $U_{max}$ = 5.1 *$\sqrt{2}$ = 7.2kV. The free border between the edge 16 of the metal layer 5 and an edge 18 of the insulating substrate 2 is typically 2 mm. Thus, the length L is normally limited by 2 mm if applying the field grading means 17 on the metallization free border of the insulating substrate 2. Consequently, a field grading means with a switching field strength of above 1.8kV/mm (=0.5 x Umax/L) would be suitable to grade the electric field along the metallization free border of the insulating substrate 2.

For the field grading means 17, according to the first embodiment of the invention, a material is chosen with a nonlinearity coefficient $\alpha$ larger than 2, in particular lager than 5 and preferably larger than 10. The larger the nonlinearity coefficient $\alpha$ is, the smaller the switching range of the material becomes. Thus, the characteristic field strength-curve 19 approaches to a step function and the switching field strength $E_c$ becomes well defined. Large nonlinearity coefficients $\alpha$ also reduce leakage currents and provide a penetration length that is not much affected by frequency.

The frequency independence is of importance since it guarantees the transferability of test results, usually performed at 50Hz, to the much higher frequency components, to which power electronic modules are exposed to in operation.

The field grading means 17 according to the first embodiment comprises an insulating matrix in which the granular material with varistor properties is embedded as a filler. Such a filler is also referred to as a microvaristor filler. The microvaristor filler is preferably granular doped zinc oxide (ZnO). Such ZnO has a high non-linearity coefficient and the electric characteristics, like the switching field strength of ZnO, can be widely tailored by specific doping and processing. However, other particles like doped tin dioxide ($SnO_2$) or silicon carbide (SiC) or carbon black might be used as varistor filler for the field grading means 17 as well.

The microvaristor filler made of doped polycrystalline ZnO is based on particles with a granulation size, i.e., diameters, of less than 100 $\mu$m, preferably less than 50 $\mu$m and most preferably less than 30 $\mu$m. Small granulation size is preferred since in this way particles can come closer to the critical edges 12 to 16 of the electronic device 1 in order to grade the electric field at these edges 12 to 16.

In a preferred embodiment, the problem that the electric field should be graded as close to the edges 12 to 16 as possible, can also be resolved by adding additional fillers to the matrix with field grading performance. Micron or submicron scale particles exist for refractive or linearly resistive field grading. $BaTiO_3$ is an example for a high-permittivity

(high-$\varepsilon$) filler material for refractive field grading and semiconductor fillers like $SnO_2$ or carbon black or coated micromica can be used for linear resistive field grading. The mixture of microvaristor filler and smaller-sized semiconductor and/or high-$\varepsilon$ fillers/filler can prevent partial discharges in the vicinity of the edges 12 to 16. An advantageous size range of the additional fillers from below 1 $\mu$m up to 10$\mu$m is used. Attention has to be drawn to the amount of semiconductor filler. The semiconductor filler should remain under the percolation threshold. Otherwise, the semiconductor filler bridges the microvaristor particles and bypasses the non-linear resistance-effect of the microvaristor particles. High-permittivity means a relative permittivity which is higher than the one of the insulating varistor matrix, and preferably also higher that the one of the insulating substrate, in particular a relative permittivity which is higher than 10.

Fig. 1 shows only exemplary field grading means 17 with the length L. The shape of the field grading means 17 is not restricted to the shown geometry. The length L should be large to prevent partial discharge or electrical breakdown at the end of the field grading means 17 (whereby "end" is a position x = L, with x denoting the distance from the metallisation edge along the field grading means).

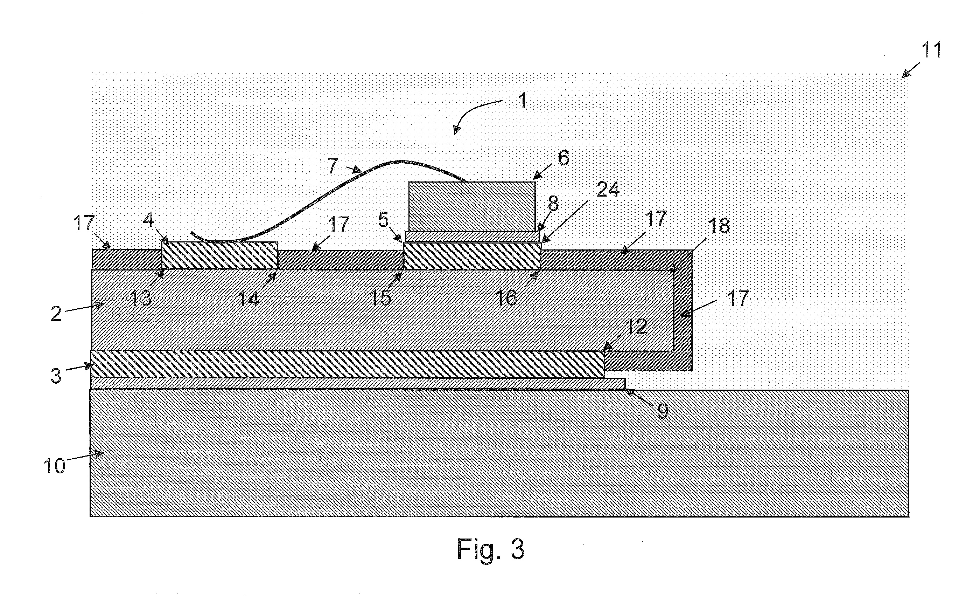

Fig. 3 shows a cross-section of a part of an electronic device 1 according to a second embodiment of the invention. For the sake of brevity, means of the second embodiment being equal to means of the first embodiment show the same reference numbers and their repetitive description is omitted. The field grading means 17 according to the second embodiment is located between two metal layers 4 and 5 on the substrate 2. This field grading means 17 contacts the metal layer 4 as well as the metal layer 5. The field grading means 17 is located along the edge 14 of the metal layer 4 as well as along the edge 15 of the metal layer 5. This has the advantage that only one layer of the field grading means 17 is needed for two edges 14 and 15. In addition, edges between the substrate 2 and the field grading means as in the first embodiment of the invention are prevented. The field grading means 17 further encloses one side surface of the substrate 2 connecting the first side and the second side of the substrate 2 from the edge 16 of the metal layer 5 being closest to the side surface of the substrate 2 on the second side up to the edge 12 of the metal layer 3 on the first side of the substrate 2. Thus, all the edges of the substrate 2 are covered by the field grading means 17. Consequently, high field strengths and possible discharges at the edges of the substrate 2 are prevented. In addition, the length of the field grading means 17 is increased such that materials with lower switching electric field strengths can be used.

In another embodiment of the invention, one field grading means encapsulates all metal layers 4, 5 and 3 on both sides of the substrate 2. Consequently, the edges like 24 of the metal layers 4 and 5 creating high electric field strengths and even edges of the semiconductor chips 6 are covered by the field grading means and the probability of partial discharges at these locations is reduced.

In a further embodiment, the microvaristor filler can also be mixed into the encapsulating soft dielectric 11 instead of an extra layer as shown in the first and second embodiment. Thus, in this embodiment the field grading means is formed by the soft dielectric which shows a non-linear resistivity.

The electronic device 1 according to the first or second embodiment is produced in a first step by bonding the metal layers 3, 4 and 5 on the substrate 2. This can be done for example by the techniques of active metal brazing or direct copper bonding.

In a second step, the field grading means 17 is applied on the substrate 2. There are several techniques to produce, realise and apply the field grading means 17. In a first example, the microvaristor filler is mixed in the liquid base components of the matrix, e.g., the base components of a Polyimide. The mixture is then applied by a needle-dispensing process on the substrate 2 along the edges 12 to 16 and finally cured by heat, UV radiation or other means. Alternatively, the mixture can also be printed, painted, coated or sprayed along the edges 12 to 16 and cured in a second step. This applies also for mixtures of matrix with different sized fillers.

Alternatively, the substrate can be prepared with and adhesive or binder in a first step and the microvaristor filler and possibly additional fillers can be mixed among each other and directly placed along the edges 12 to 16 in a second step.

If the microvaristor particles, i.e., the layer of microvaristor particles, are not fully embedded by a polymer matrix, it is advantageous to seal the particles with a thin passivation layer, for example by a polymer film in a third step. If microvaristor particles are not sealed, then they can react with the environment, in particular with the reducing atmosphere applied during soldering of substrates on the base plate 10. This chemical reaction can change the electrical characteristics of the microvaristor particles and thereby reduce their capability for field grading. A possible polymer for the passivation layer is Polyimide. Also non-polymeric sealing layers are possible, such as glass.

As already mentioned, the field grading means 17 can be realised as a layer or as an encapsulation, i.e., by adding the fillers into the encapsulation material 11. Alternative encapsulations to Silicone gel are other dielectric gels or dielectric liquids or inert gas.

The invention has been described in detail with particular reference to preferred embodiments thereof and examples, but it will be understood that variations and modifications can be effected within the spirit and scope of the invention covered by the claims which may allow different types of field grading means.

1        electronic device

| 2 | insulating substrate |
| 3, 4, 5 | metal layers |
| 6 | chip |
| 7 | wire |
| 8 | soldering layer |
| 9 | another solder layer |
| 10 | base plate |
| 11 | soft dielectric |
| 12-16 | edge |
| 17 | field grading means |
| 18 | edge |
| 19 | field strength-curve |
| 24 | edge |
| Ec | switching field strength |
| 20, 21 | vertical line |
| p | electrical resistivity |
| E | electric field strength |
| $\alpha$ | nonlinearity coefficient |
| j | current density |
| $U_{max}$ | maximum voltage during a critical test |
| L | dimension of the field grading means 17 |
| $\varepsilon$ | permittivity |

**Claims**

1. Electronic device comprising an insulating substrate (2) for carrying semiconductor components (6), at least one metal layer (3, 4, 5) formed on the substrate (2) and a field grading means (17) located on the substrate (2) along at least one edge (12 to 16) formed between the at least one metal layer (3, 4, 5) and the insulating substrate (2), **characterized in that** the field grading means (17) has a non-linear electrical resistivity.

2. Electronic device according to claim 1, **characterized in that** the field grading means (17) is located along at least 50% of the length of the edge (12 to 16) around at least one of the metal layer (3, 4, 5), preferably along at least 80% of the length and most preferably at least 90% of the length of the edge (12 to 16).

3. Electronic device according to claim 2, **characterized in that** the field grading means is located along at least 50%, preferably 80% and most preferably at least 90% of the length of the edge (12. to 16) around all the metal layers (3, 4, 5) on at least one side of the substrate (2).

4. Electronic device according to one of the claims 1 3, **characterized in that** at least two metal layers (3, 4, 5) are formed on the substrate (2) and the field grading means (17) is located on the substrate (2) along at least one edge (12 to 16) of each of the at least two metal layers (3, 4, 5).

5. Electronic device according to one of the claims 1 to 4, **characterized in that** a characteristic current density -electric field strength -curve (19) of the field grading means (17, 23) shows a nonlinearity-coefficient larger than two at a switching field strength.

6. Electronic device according to claim 5, **characterized in that** the switching field strength is larger than half of the ratio of the maximum critical test voltage of the electronic device and the length (L) of the field grading means (17) in the direction of the substrate surface.

7. Electronic device according to one of claims 1 to 6, **characterized in that** the field grading means (17) comprises an insulating matrix filled with particles having non-linear electrical resistivity.

8. Electronic device according to claim 7, **characterized in that** the insulating matrix comprises at least one further filler, wherein the filler is a semiconductor or a high permittivity material.

9. Electronic device according to claim 8, **characterized in that** the at least one further filler has a reduced particle size compared to filler with non-linear electrical resistivity.

10. Electronic device according to claim 1 to 6, **characterized in that** the field grading means is composed of particles having non-linear electrical resistivity, which are bonded on the substrate (2).

11. Electronic device according to claim 7 to 10, **characterized in that** the non-linear resistive particles of the field grading means (17) are granular microvaristors made of doped polycrystalline zinc oxide.

12. Electronic device according to one of claims 1 to 11, **characterized in that** the field grading means is sealed with a passivation layer.

13. Electronic device according to one of claims 1 to 12, **characterized in that** the electronic device is part of a power electronic module, in particular an IGBT module.

14. Method for producing an electronic device, in particular for producing an electronic device according to one of the claims 1 to 13, comprising the steps of:

forming at least one metal layer (3, 4, 5) on a insulating substrate (2),
followed by
arranging a field grading means (17) with non-linear electrical resistivity on at least one of the edges (12 to 16) of the metal layers (3, 4, 5).

15. Method according to claim 14, **characterized by** mixing fillers with non-linear electrical resistivity and optional other fillers in an insulating matrix followed by
needle-dispensing or printing or painting or coating or spraying the mixture on the substrate (2)
followed by
curing the mixture by heat, ultraviolet radiation or other means.

16. Method according to claim 14, **characterized by** applying an adhesive or binder on the substrate
followed by
placing or pressing a filler with non-linear electrical resistivity and optional other fillers on the substrate (2).

17. Method according to one of claims 14 to 16, **characterized by** sealing the filler with a passivation layer.

18. Method for producing an electronic device comprising the steps of:

mixing fillers with non-linear electrical resistivity and optional other fillers in an insulating matrix followed by
application of the filler/matrix compound as the encapsulation of the electronic device.

Fig. 1

Fig. 2

Fig. 3

EUROPEAN SEARCH REPORT

Application Number

EP 09 17 9630

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2007/114640 A1 (KOSOWSKY LEX [US]) 24 May 2007 (2007-05-24) * paragraph [0025] - paragraph [0041]; figures 1-9 * * paragraphs [0028], [0029] * ----- | 1-18 | INV. H01L23/498 H01L23/62 |
| X | FR 2 513 032 A1 (CARRERAS MICHELLE [FR]) 18 March 1983 (1983-03-18) * figures 2,3,5 * ----- | 1-18 | |
| X | EP 1 990 834 A2 (TEXAS INSTRUMENTS FRANCE [FR]) 12 November 2008 (2008-11-12) * figure 2 * ----- | 1,14 | |
| X | US 5 974 661 A (NEUHALFEN ANDREW J [US]) 2 November 1999 (1999-11-02) * figures 11-13 * ----- | 1-18 | |
| X | US 3 916 366 A (JEFFERSON CLINTON F) 28 October 1975 (1975-10-28) * figures 1-4 * ----- | 1-18 | TECHNICAL FIELDS SEARCHED (IPC) H01L |

The present search report has been drawn up for all claims

| Place of search | Date of completion of the search | Examiner |
|---|---|---|
| The Hague | 9 March 2010 | Kästner, Martin |

**ANNEX TO THE EUROPEAN SEARCH REPORT
ON EUROPEAN PATENT APPLICATION NO.**

EP 09 17 9630

This annex lists the patent family members relating to the patent documents cited in the above-mentioned European search report.
The members are as contained in the European Patent Office EDP file on
The European Patent Office is in no way liable for these particulars which are merely given for the purpose of information.

09-03-2010

| Patent document cited in search report | | Publication date | Patent family member(s) | | Publication date |
|---|---|---|---|---|---|
| US 2007114640 | A1 | 24-05-2007 | NONE | | |
| FR 2513032 | A1 | 18-03-1983 | EP | 0088081 A1 | 14-09-1983 |
| | | | WO | 8301153 A1 | 31-03-1983 |
| EP 1990834 | A2 | 12-11-2008 | US | 2008278873 A1 | 13-11-2008 |
| US 5974661 | A | 02-11-1999 | NONE | | |
| US 3916366 | A | 28-10-1975 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6310401 B
- US 20010014413 A

**Non-patent literature cited in the description**

- **RHYNER et al.** One-dimensional model for nonlinear stress control in cable terminations. *IEEE Transactions on Dielectrics and Electrical Insulation,* 1997, vol. 4 (6), 785-791